# FASCICULE DE BREVET EUROPEEN

(11) **EP 1 450 169 B1**
(45) Date de publication et mention de la délivrance du brevet: **10.05.2006**
(21) Numéro de dépôt: 04290442.5
(22) Date de dépôt: 19.02.2004
(51) Int. Cl.: G01R 19/155, G01R 1/067

(54) **Tournevis à haute isolation électrique, indicateur de présence de phase**
Schraubendreher mit einer hohen elektrischen Potentialtrennung, Anzeige der Anwesenheit von Phase
Screwdiver having high electric isolation, indicator of the presence of a phase

(30) Priorité: 24.02.2003 FR 0302239
(43) Date de publication de la demande: 25.08.2004
(73) Titulaire: SOCIETE ANONYME DES ETS CATU, F-92220 Bagneux (FR)
(72) Inventeur: Bouchez, Bernard, Rés "Les Jardins de Bagneux", 92220 Bagneux (FR)
(74) Mandataire: Quantin, Bruno Marie Henri

(56) Documents cités:
- DE-A- 3 437 320
- US-A- 4 724 382
- US-A- 5 952 820
- US-A- 6 100 679

## Description

La présente invention concerne un tournevis à haute isolation électrique, indicateur de présence de phase.

Généralement, la présence de phase haute tension unipolaire, au contact nécessite un certain nombre d'éléments dont un capteur, une alimentation, un moyen de traitement électronique de l'information donnée par le capteur et un organe de signalisation indiquant la présence de phase; ces éléments sont jusqu'ici reliés entre eux par des fils et dès lors la manipulation n'est pas toujours aisée pour l'usager.

On connaît déjà du brevet américain 6,100,679 un tournevis pour indiquer la présence de phase comportant une lame, un manche formé d'un corps en matière isolante entourant ladite lame et, dans ledit manche, les éléments destinés à obtenir, d'une seule main, une indication de présence de phase, à savoir, outre ladite lame, une alimentation, un moyen de traitement électrique de l'information donnée par ladite lame et un organe de signalisation.

Le manche comporte une cavité accueillant le moyen de traitement électrique et l'alimentation ainsi qu'une ouverture entre ladite lame et ladite cavité.

La présente invention a pour but de fournir un tel type de tournevis dans lequel sont intégrés de façon compacte l'ensemble de ces éléments dans le corps d'un tournevis à haute isolation électrique.

Ainsi, l'invention propose un tournevis à haute isolation électrique comportant une lameun manche formé d'un corps en matière isolante entourant ladite lame et, dans ledit manche, les éléments destinés à obtenir, d'une seule main, une indication de présence de phase, à savoir, outre ladite lame, une alimentation, un moyen de traitement électrique de l'information donnée par ladite lame et un organe de signalisation, caractérisé en ce que l'alimentation est une pile plate et ledit manche comporte une extrémité présentant une cavité à l'intérieur de laquelle fait saillie ladite lame pour venir électriquement en contact avec le boîtier de la pile

De préférence, ce contact est obtenu par l'intermédiaire d'un ressort que la lame porte en bout.

De préférence, ladite pile, un circuit imprimé portant le moyen de traitement de l'information et l'organe de signalisation prennent place dans ladite cavité, laquelle est fermée vers l'extérieur par un bouchon.

Avantageusement, la pile est soudée au circuit imprimé.

De préférence, le bouchon porte une jupe adaptée à coopérer avec la paroi latérale interne de la cavité.

De préférence, le bouchon porte un rebord périphérique destiné à être solidarisé au corps du tournevis.

Avantageusement, l'organe de signalisation est un organe de signalisation lumineuse et le bouchon est au moins en partie translucide.

De préférence, le moyen de traitement comprend une résistance de charge de très haute valeur, un étage adaptateur d'impédance, un filtre intégrateur anti-étincelage, un oscillateur et un étage adaptateur de puissance qui pilote l'organe de signalisation.

Avantageusement, la face du circuit imprimé tournée vers l'extérieur est métallisée, avantageusement cuivrée, et associée électriquement à la résistance de charge.

De préférence, l'étage adaptateur d'impédance est un étage logique qui met en forme le signal sinusoïdal recueilli aux bornes de la résistance de charge et le transmet au filtre intégrateur anti-étincelage qui transforme le signal périodique qu'il reçoit en un signal continu logique zéro ou un.

Avantageusement, l'oscillateur est un oscillateur bloqué à très basse fréquence et à très grand rapport cyclique.

De préférence, le rapport cyclique de l'oscillateur est supérieur à 40.

Pour mieux faire comprendre l'objet de l'invention, on va en décrire maintenant, à titre d'exemple, purement illustratif et non limitatif, des modes de réalisation représentés sur les dessins annexés.

Sur ces dessins :
- la figure 1 est une vue de dessus d'un tournevis selon l'invention;
- la figure 2 est une vue en coupe du tournevis de la figure 1 ;
- la figure 3 est une vue en coupe éclatée du tournevis de la figure 1 ;
- la figure 4 est une vue de côté du sous-ensemble constitué par le circuit imprimé et la pile qu'il porte ;
- la figure 5 est une vue selon la flèche V de la figure 4 ;
- la figure 6 est un diagramme montrant la constitution du moyen de traitement de l'information.

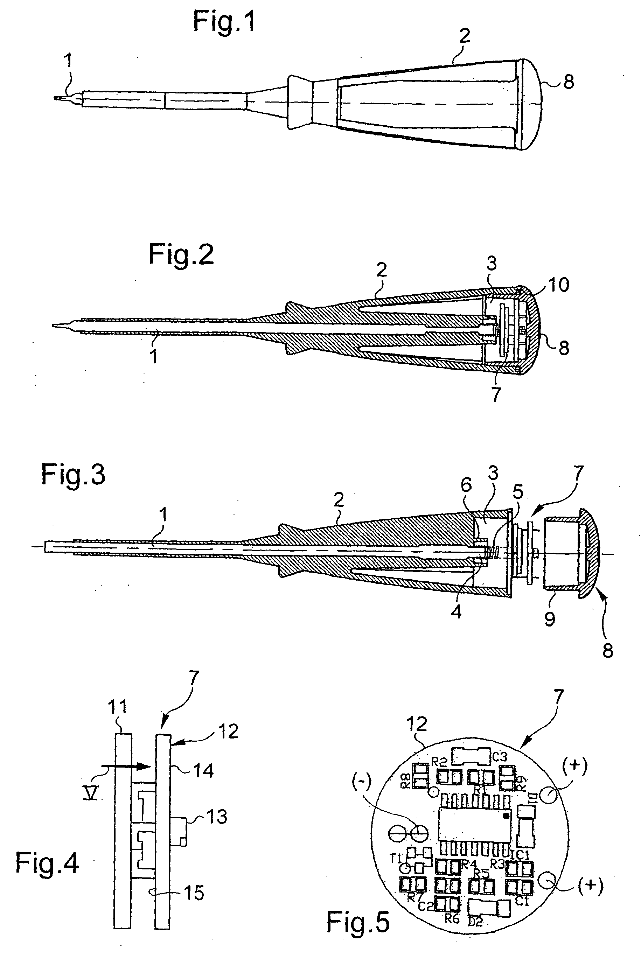

Les figures 1 à 3 montrent un tournevis selon l'invention.

Celui-ci comprend une lame 1 entourée d'un corps 2 en matière isolante formant un manche dont l'extrémité présente une cavité 3 ouverte vers l'extérieur.

La lame 1 fait saillie dans cette cavité 3 selon une queue 4 qui porte un ressort hélicoïdal 5 dont le rôle apparaîtra ci-après ; avantageusement, une collerette 6 venue de moulage entoure la queue 4 de la lame 1 et, en partie, le ressort hélicoïdal 5 agrafé par ses spires sur ladite queue 4.

La cavité 3 est adaptée à recevoir un sous-ensemble 7 comprenant l'alimentation, un circuit imprimé portant le moyen de traitement de l'information et l'organe de signalisation.

Plus précisément, le sous-ensemble 7 comprend, figures 4 et 5, une pile plate 11 soudée sur un circuit imprimé 12 qui porte, sur sa face 14 tournée vers l'extérieur, l'organe de signalisation, ici une diode électro-luminescente 13 et, sur sa face 15 tournée vers la pile 11, le moyen de traitement de l'information, figure 5.

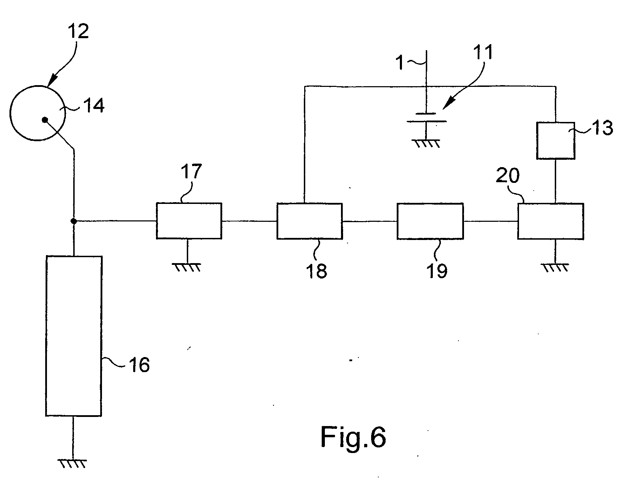

Les composantes du moyen de traitement de l'information sont montrées schématiquement figure 6.

Une résistance de charge 16 de très haute valeur, constituée d'une seule résistance ou de plusieurs résistances en série, est reliée à une capacité constituée par une couche métallique, telle qu'une couche de cuivre, couvrant la face 14 du circuit imprimé 12 ; à cette capacité s'ajoute celle du corps de l'usager qui a le tournevis en main ; dès lors, lorsqu'un réseau est testé, une différence de potentiel alternative, à la fréquence de la phase du réseau, apparaît aux bornes de la résistance 16 du fait de la circulation d'un micro-courant entre la lame 1 du tournevis et le sol.

Un étage logique 17 adaptateur d'impédance met en forme le signal reçu aux bornes de la résistance 16 et le transmet à un filtre intégrateur anti-étincelage 18 relié, comme la lame 1 du tournevis, au pôle positif de la pile 11 ; ce filtre intégrateur 18 veille à ne pas laisser passer des amorçages intempestifs et transforme le signal périodique issu de l'étage adaptateur 17 en un signal continu logique, zéro ou un.

Ce signal logique, lorsqu'il est à zéro, autorise le fonctionnement d'un oscillateur bloqué 19 à très basse fréquence, de l'ordre de 2 Hertz, et à très grand rapport cyclique, notamment supérieur à 40, qui commande un étage 20 adaptateur de puissance qui lui-même pilote l'organe de signalisation 13, ici une diode électroluminescente alimentée par la pile 11.

Grâce au choix ci-dessus de l'oscillateur, l'organe de signalisation 13 émet des éclairs puissants pendant un temps très court, de l'ordre de 10 millisecondes par exemple, avec une récurrence très longue, de l'ordre de 450 millisecondes par exemple : ainsi, en utilisant une pile 11 qui a trois cents heures d'autonomie, il n'est pas utile de rendre la pile interchangeable ; elle peut ainsi être soudée sur le circuit imprimé 12 et l'isolation du tournevis peut être réalisée de manière fiable, l'ensemble pouvant être hermétique ; cette isolation peut être une isolation à 10000 volts.

Le sous-ensemble 7 est disposé à l'intérieur de la cavité 3 fermée ensuite par un bouchon 8 qui applique le sous-ensemble 7, donc la pile 11, contre le ressort 5 qui relie alors électriquement celle-ci à la lame 1 du tournevis.

Le bouchon 8 porte une jupe 9 adaptée à coopérer avec la paroi latérale intérieure de la cavité 3 en s'adaptant à celle-ci; le bouchon 8 présente également un rebord périphérique transversal destiné à être collé en 10 au corps 2 du tournevis, en bout de celui-ci ; le bouchon 8 est avantageusement au moins en partie translucide.

Ainsi, le tournevis selon l'invention combine en un seul appareil deux fonctions, la fonction tournevis et la fonction indicateur de phase ; le tournevis est isolé 1000 volts et la détection de phase est possible dans la plage 50 à 1000 volts, grâce notamment à la face 14 métallisée du circuit imprimé 12.

On aura noté également qu'en dehors de l'extrémité de la lame 1 aucune partie métallique n'est accessible lorsque le corps 2 est en main ; de plus, la face 14 métallisée du circuit imprimé 12 est de taille suffisante pour permettre l'usage des gants isolants et/ou l'utilisation d'un tabouret ou d'un tapis lors de la mesure.

## Revendications

1. Tournevis à haute isolation électrique comportant une lame (1), un manche formé d'un corps en matière isolante entourant ladite lame et, dans ledit manche, les éléments destinés à obtenir, d'une seule main, une indication de présence de phase, à savoir, outre ladite lame (1), une alimentation (11), un moyen de traitement électrique de l'information donnée par ladite lame et un organe de signalisation (13), **caractérisé en ce que** l'alimentation est une pile plate (11) et ledit manche comporte une extrémité présentant une cavité (3) à l'intérieur de laquelle fait saillie ladite lame (1) pour venir électriquement en contact avec le boîtier de la pile (11).

2. Tournevis selon la revendication 1, **caractérisé par le fait que** ce contact est obtenu par l'intermédiaire d'un ressort (5) que la lame (1) porte en bout.

3. Tournevis selon l'une des revendications 1 ou 2, **caractérisé en ce que** ladite pile (11), un circuit imprimé (12) portant le moyen de traitement de l'information et l'organe de signalisation (13) prennent place dans ladite cavité (3), laquelle est fermée vers l'extérieur par un bouchon (8).

4. Tournevis selon la revendication 3, **caractérisé par le fait que** la pile (11) est soudée au circuit imprimé (12).

5. Tournevis selon l'une des revendications 3 ou 4, **caractérisé par le fait que** le bouchon (8) porte une jupe (9) adaptée à coopérer avec la paroi latérale interne de la cavité (3).

6. Tournevis selon l'une des revendications 3 à 5, **caractérisé par le fait que** le bouchon (8) porte un rebord périphérique destiné à être solidarisé au corps (2) du tournevis.

7. Tournevis selon l'une des revendications 3 à 6, **caractérisé par le fait que** l'organe de signalisation (13) est un organe de signalisation lumineuse et le bouchon (8) est au moins en partie translucide.

8. Tournevis selon l'une des revendications 1 à 7, **caractérisé par le fait que** le moyen de traitement comprend une résistance de charge (16) de très haute valeur, un étage (17) adaptateur d'impédance, un filtre intégrateur (18) anti-étincelage, un oscillateur (19) et un étage adaptateur de puissance (20) qui pilote l'organe de signalisation (13).

9. Tournevis selon la revendication 8, **caractérisé par le fait qu'**un circuit imprimé (12) portant lemoyen de traitement de l'information est adapté à prendre place dans la cavité (3) et la face (14) du circuit imprimé (12) tournée vers l'extérieur est métallisée, avantageusement cuivrée, et associée électriquement à la résistance de charge (16).

10. Tournevis selon l'une des revendications 8 ou 9, **caractérisé par le fait que** l'étage (17) adaptateur d'impédance est un étage logique qui met en forme le signal sinusoïdal recueilli aux bornes de la résistance de charge (16) et le transmet au filtre intégrateur (18) anti-étincelage qui transforme le signal périodique qu'il reçoit en un signal continu logique zéro ou un.

11. Tournevis selon l'une des revendications 8 à 10, **caractérisé par le fait que** l'oscillateur est un oscillateur (19) bloqué à très basse fréquence et à très grand rapport cyclique.

12. Tournevis selon la revendication 11, **caractérisé par le fait que** le rapport cyclique de l'oscillateur (19) est supérieur à 40.

## Patentansprüche

1. Schraubendreher hoher elektrischer Isolation, umfassend eine Klinge (1), einen Handgriff, der aus einem Körper aus isolierendem Material gebildet ist, welcher die Klinge umgibt, und in dem Handgriff die Elemente, die zum Erhalten mit einer einzigen Hand einer Anzeige einer Anwesenheit von Phase bestimmt sind, nämlich neben der Klinge (1) eine Versorgung (11), Mittel zur elektrischen Behandlung von Information, welche durch die Klinge gegeben ist, und ein Signalisierorgan (13), **dadurch gekennzeichnet, daß** die Versorgung eine flache Batterie (11) ist und der Handgriff ein Ende umfaßt, welches einen Hohlraum (3) aufweist, in dessen Inneres die Klinge (1) vorragt, um elektrisch in Kontakt mit dem Gehäuse der Batterie (11) zu gelangen.

2. Schraubendreher nach Anspruch 1, **dadurch gekennzeichnet, daß** der Kontakt durch Zwischenschaltung einer Feder (5) erhalten ist, welche die Klinge (1) am Ende trägt.

3. Schraubendreher nach einem der Ansprüche 1 oder 2, **dadurch gekennzeichnet, daß** die Batterie (11), eine gedruckte Schaltung (12), welche die Mittel zur Behandlung von Information trägt, und das Signalisierorgan (13) in dem Hohlraum (3) angeordnet sind, welcher gegen das Äußere durch einen Stopfen (8) verschlossen ist.

4. Schraubendreher nach Anspruch 3, **dadurch gekennzeichnet, daß** die Batterie (11) mit der gedruckten Schaltung (12) verschweißt ist.

5. Schraubendreher nach einem der Ansprüche 3 oder 4, **dadurch gekennzeichnet, daß** der Stopfen (8) einen Mantel (9) trägt, der adaptiert ist, um mit der inneren Seitenwand des Hohlraums (3) zu kooperieren.

6. Schraubendreher nach einem der Ansprüche 3 bis 5, **dadurch gekennzeichnet, daß** der Stopfen (8) einen Umfangsrand trägt, der dazu bestimmt ist, mit dem Körper (2) des Schraubendrehers verbunden zu werden.

7. Schraubendreher nach einem der Ansprüche 3 bis 6, **dadurch gekennzeichnet, daß** das Signalisierorgan (13) ein Lichtsignalisierorgan ist und der Stopfen (8) wenigstens teilweise durchscheinend ist.

8. Schraubendreher nach einem der Ansprüche 1 bis 7, **dadurch gekennzeichnet, daß** die Behandlungsmittel einen Ladungswiderstand (16) mit sehr hohen Wert, eine Impedanzadaptierstufe (17), ein Antifunkenintegratorfilter (18), einen Oszillator (19), und eine Leistungsadaptierungsstufe (20) umfassen, welche das Signalisierorgan (13) steuern.

9. Schraubendreher nach Anspruch 8, **dadurch gekennzeichnet, daß** eine gedruckte Schaltung (12), die die Mittel zur Behandlung von Information trägt, adaptiert ist, um in dem Hohlraum (3) angeordnet zu werden, und die Seite bzw. Fläche (14) der gedruckten Schaltung (12), die nach außen gerichtet ist, metallisiert, vorteilhaft mit Kupfer versehen ist, und elektrisch mit dem Ladungswiderstand (16) assoziiert ist.

10. Schraubendreher nach einem der Ansprüche 8 oder 9, **dadurch gekennzeichnet, daß** die Impedanzadaptierungsstufe (17) eine Logikstufe ist, welche das sinusartige Signal, welches an Klemmen des Ladungswiderstands (16) aufgenommen ist, in Form bringt und es zu dem Antifunkenintegratorfilter (18) überträgt, welches das periodische Signal transformiert, daß es ein logisches kontinuierliches Signal Null oder eins erhält.

11. Schraubendreher nach einem der Ansprüche 8 bis 10, **dadurch gekennzeichnet, daß** der Oszillator ein Oszillator (19) ist, der bei sehr niedriger Frequenz und bei sehr großem zyklischem Verhältnis blockiert ist.

12. Schraubendreher nach Anspruch 11, **dadurch gekennzeichnet, daß** das zyklische Verhältnis des Oszillators (19) größer als 40 ist.

## Claims

1. A screwdriver with high electrical insulation comprising a blade (1), a handle formed by a body of insulating material surrounding said blade and, in said handle, the components adapted to obtain, using a single hand, an indication of the presence of phase, that is to say, in addition to said blade (1), a power supply (11), a means for electrical processing of information given by said blade and a signaling device (13), **characterized in that** the power supply is a flat cell (11) and said handle comprises an end having a cavity (3) within which said blade (1) projects to come into electrical contact with the casing of the cell (11).

2. A screwdriver according to claim 1, **characterized by** the fact that said contact is obtained through a spring (5) which the blade (1) bears on its end.

3. A screwdriver according to one of claims 1 or 2, **characterized in that** said cell (11), a printed circuit (12) bearing the information processing means and the signaling device (13), are located in said cavity (3), the latter being closed to the outside by a stopper (8).

4. A screwdriver according to claim 3, **characterized by** the fact that the cell (11) is soldered to the printed circuit (12).

5. A screwdriver according to one of claims 3 or 4, **characterized by** the fact that the stopper (8) bears a skirt (9) adapted to cooperate with the inner side wall of the cavity (3).

6. A screwdriver according to one of claims 3 to 5, **characterized by** the fact that the stopper (8) bears a peripheral rim adapted to be joined to the body (2) of the screwdriver.

7. A screwdriver according to one of claims 3 to 6, **characterized by** the fact that the signaling device (13) is a luminous signaling device and the stopper (8) is at least partly translucent.

8. A screwdriver according to one of claims 1 to 7, **characterized by** the fact that the processing means comprises a load resistor (16) of very high value, an impedance matching stage (17), an anti-sparking averaging filter(18), an oscillator (19) and a power adaptor stage (20) which drives the signaling device (13).

9. A screwdriver according to claim 8, **characterized by** the fact that a printed circuit (12) bearing the information processing means is adapted to be located in the cavity (3) and the outwardly turned face (14) of the printed circuit (12) is metal-coated, advantageously copper-coated, and electrically associated with the load resistor (16).

10. A screwdriver according to one of claim 8 or 9, **characterized by** the fact that the impedance matching stage (17) is a logic stage which puts into form the sinusoidal signal collected at the terminals of the load resistor (16) and transmits it to the anti-sparking averaging filter (18) which transforms the periodic signal which it receives into a zero or one logical continuous signal.

11. A screwdriver according to one of claims 8 to 10, **characterized by** the fact that the oscillator is an oscillator (19) fixed at very low frequency and with a very high mark/space ratio.

12. A screwdriver according to claim 11, **characterized by** the fact that the mark/space ratio of the oscillator (19) is greater than 40.
